# EUROPEAN PATENT APPLICATION

(11) **EP 1 890 521 A1**
(43) Date of publication of application: **20.02.2008**
(21) Application number: 06756994.7
(22) Date of filing: 05.06.2006
(51) Int. Cl.: H04R 19/01, H01G 7/02, H04R 31/00

(54) **METHOD OF TURNING CONDENSER MICROPHONE INTO ELECTRET, ELECTRET-TURNING DEVICE AND METHOD OF PRODUCING CONDENSER MICROPHONE USING THIS**

(30) Priority: 06.06.2005 JP 2005165754
(71) Applicant: MATSUSHITA ELECTRIC INDUSTRIAL CO., LTD., Osaka 571-8501 (JP)
(72) Inventor: TAKEUCHI, Yusuke c/o Matsushita Electric Industrial Co, Ltd, 2-1-61 Shiromi, Chuo-ku Osaka 540-6207 (JP); OGURA, Hiroshi c/o Matsushita Electric Industrial Co, Ltd, 2-1-61 Shiromi, Chuo-ku Osaka 540-6207 (JP); MAKIHATA, Katuhiro c/o Matsushita Electric Industrial Co, Ltd, 2-1-61 Shiromi, Chuo-ku Osaka 540-6207 (JP)
(74) Representative: Grünecker, Kinkeldey, Stockmair & Schwanhäusser Anwaltssozietät
(86) International application number: PCT/JP2006/311248
(87) International publication number: WO 2006/132193

(57) **Abstract**

A new electretization technology for a silicon microphone capable of reasonably electretizing a dielectric film of a condenser microphone formed by micromachining a silicon substrate and also capable of taking measures against variations in the microphone sensitivity caused by manufacturing variations and characteristic variations in parts is provided.

A silicon microphone chip is completed and is implemented on an printed-circuit board and in this state, electretization processing is executed separately for a dielectric film in one silicon microphone chip by executing corona discharge using one needle electrode 51. More than one electretization is executed and the second or later electretization quantity is determined adaptively based on the actual measurement result of the microphone sensitivity, whereby electretization of the dielectric film is executed precisely and efficiently.

## Description

### <Technical Field>

This invention relates to an electretization method of a condenser microphone, an electretization apparatus, and a manufacturing method of a condenser microphone using it and in particular to an electretization method of a dielectric film in a condenser microphone formed using a fine patterning technology of a semiconductor substrate of silicon, etc., and an electretization apparatus.

### <Background Art>

An electret-condenser microphone (ECM) is a small-sized acousto-electric converter for detecting capacity change of a condenser caused by a sound wave as an electric signal and using an electret film having semi-permanent polarization, thereby eliminating the need for DC bias of the condenser.

The electret film (dielectric film with at least a part polarized) in an ECM is made of an organic dielectric film of FEP (fluorinated ethylene propylene), etc., for example, and is formed by injecting charges into the dielectric film and fixing. An electric field formed by the charges injected into the dielectric film causes a potential different to occur across a condenser. Injecting charges into a dielectric film and fixing is called electretization.

The dielectric film (electret film) is formed of a thin film of FEP, etc., and metal of nickel, etc., is deposited on the outer face of the film by evaporation, etc.

As an injection method of charges into a dielectric film for electret formation, methods shown in FIGS. 7 and 8 are available (for example, refer to non-patent document 1 and patent document 1).

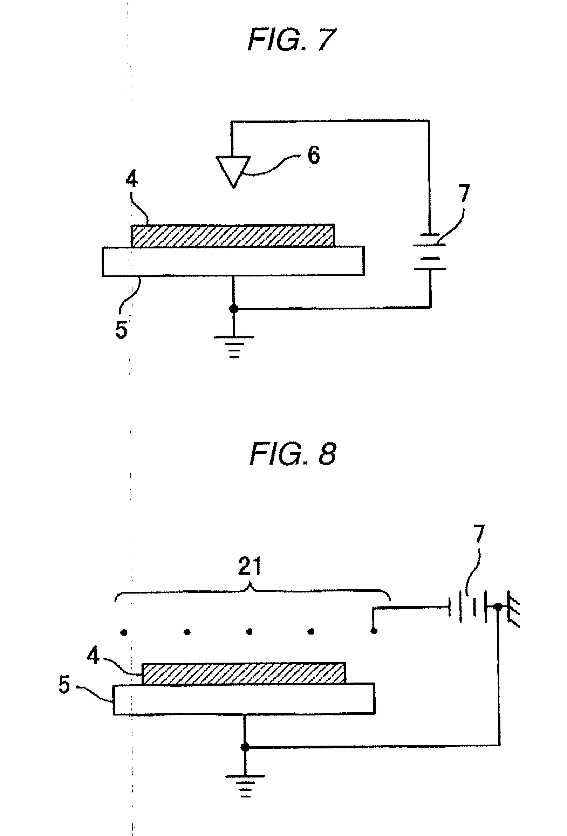

FIG. 7 is a sectional view of the main part of an apparatus for electretizing a dielectric film by causing corona discharge to occur using a needle electrode.

In the apparatus in FIG. 7, an FEP (fluorinated ethylene propylene) thin film 4 is placed on a ground electrode (metal tray) 5, DC corona discharge is caused to occur with a needle electrode 6, and ions are implanted into the FEP thin film 4 and are fixed, thereby electretizing. Reference numeral 7 denotes a high voltage source.

FIG. 8 is a sectional view of the main part of an apparatus for electretizing a dielectric film by causing corona discharge to occur using a wire electrode. Parts common to those of the apparatus in FIG. 7 are denoted by the same reference numerals in FIG. 8.

In the apparatus in FIG. 8, an FEP (fluorinated ethylene propylene) thin film 4 is placed on a ground electrode (metal tray) 5, DC corona discharge is caused to occur with a wire electrode 21, and ions are implanted into the FEP thin film 4 and are fixed, thereby electretizing. The apparatus in FIG. 8 can apply ions in a wide range because the wire electrode 21 has a two-dimensional spread.

Therefore, usually, to manufacture ECMs, considering mass productivity, a plurality of FEP thin films (dielectric films) are arranged on a metal tray and corona discharge is made in the apparatus in FIG. 8, thereby electretizing a large quantity of FEPs at a time. In this method, however, ions may not uniformly be applied and thus the electret quantity may vary from one position to another on the tray. Accordingly, variations occur in the sensitivity of each microphone. In addition, sensitivity variations may be caused to occur by variations in parasitic capacity, FET capacity, etc.

In the related arts described above, the dielectric film to be electretized is taken out and electretization processing is performed. It can be said that the technology is technology assuming the ECM formed by assembling mechanical parts.

In contrast, in recent years, an art of micromachining a silicon substrate to form a microminiature condenser microphone rather than assembling mechanical parts has been proposed (for example, refer to patent documents 2, 3, and 4).

A condenser microphone of silicon manufactured using a manufacturing technology of so-called MEMS (minute electromechanical system) is called "silicon microphone (or silicon mic)" and attention is focused as a manufacturing technology of an ECM to be installed in a mobile telephone terminal, etc., progressed in miniaturization and slimming down (for example, refer to patent document 2).

The silicon microphone is manufactured by machining a silicon substrate using semiconductor process technology and thus electretization processing not relating to semiconductor machining cannot enter the manufacturing process (namely, only a dielectric film cannot be taken out for separate etectretizing).

Therefore, the silicon microphone described in patent document 3 is a condenser microphone not including an electret film.

However, electretization in the silicon microphone cannot be accomplished and electretization of a dielectric film is made possible in the silicon microphone described in patent document 4.

That is, the silicon microphone described in patent document 4 is made up of a first silicon substrate (microphone film) containing a dielectric film formed on a semiconductor substrate and a second silicon substrate (microphone back plate) put on the first silicon substrate, and electretization of a dielectric film is executed at the last of the manufacturing process of the first substrate and then the second silicon substrate is put.
Non-patent document 1: Housougijyutusha notameno maikurohon kouza (NAKAMURA Jin'ichiro Housougijyutu Kenrokukanshuppan November Shouwa 57 issue)
Patent document 1: JP-A-56-58220
Patent document 2: JP-A-11-88992
Patent document 3: JP-A-2005-20411 (FIG. 1)
Patent document 4: JP-T-2000-508860 (FIG. 1A, FIG. 1B)

### <Disclosure of the Invention>

### <Problems to be Solved by the Invention>

As described above, the silicon microphone provided by micromachining a silicon substrate using the semiconductor manufacturing process cannot essentially be electretized with only the dielectric film taken out and therefore it is hard to manufacture an ECM (electret-condenser microphone).

In the method of separating a silicon microphone into two substrates, manufacturing them separately, and putting the substrates on each other lastly as in the technology described in patent document 4, electretization of the dielectric film is possible, but the manufacturing process of the silicon microphone becomes complicated.

When the silicon substrate is micromachined, dimensions easily vary from one device to another or performance variations of electronic parts of FET (field-effect transistor), etc., installed on the printed-circuit board may be unnegligible and thus variations occur in the sensitivity of each silicon microphone. Patent document 4 does not describe any measures against such sensitivity variations of the silicon microphones.

It is therefore an object of the invention to provide a new electretization method for a silicon microphone capable of reasonably electretizing a dielectric film of a condenser microphone formed by micromachining a silicon substrate and also capable of taking measures against variations in the microphone sensitivity caused by manufacturing variations and characteristic variations in parts.

### <Means for Solving the Problems>

An electretization method of the invention is an electretization method of electretizing a dielectric film of a component of a condenser microphone after implementing the condenser microphone formed by micromachining a semiconductor substrate such as a silicon substrate on an printed-circuit board, wherein one electrode of the condenser microphone is connected to a predetermined potential through a terminal and at least one corona discharge using the electrode and a needle electrode is executed separately for the condenser microphone, thereby electretizing the dielectric film.

The silicon microphone formed using a semiconductor substrate such as a silicon substrate cannot be electretized with an electret film separately taken out. To separate a silicon microphone into two pieces for manufacturing, the manufacturing process becomes complicated. Then, in the invention, a silicon substrate is machined and (a semiconductor chip) of a condenser microphone is completed and is implemented on an printed-circuit board and in this state, a dielectric film is electretized. Electretization is executed by performing corona discharge from a needle electrode for the dielectric film of the silicon microphone and at this time, the corona discharge from one needle electrode is executed for the dielectric of one microphone separately. According to the corona discharge of the needle electrode, more ions than those of the corona discharge using a wire electrode can be applied concentratedly to the dielectric film of the microphone. Therefore, for example, if ions are applied to the dielectric film through the openings of a fixed electrode because of the structure of the microphone, an appropriate quantity of ions can be supplied and therefore the dielectric film can be electretized. Since the dielectric film of one microphone is electretized using one needle electrode, conditioning is easily carried out and therefore there is an advantage for improving accuracy of electretization.

The electretization method of the invention contains a method wherein the condenser microphone has a fixed electrode having a plurality of sound holes, a diaphram placed with a predetermined spacing from the fixed electrode, the dielectric film provided on the diaphram, and a conductive diaphram abutted against the dielectric film, and is implemented on an printed-circuit board and wherein the dielectric film in the condenser microphone is provided on the printed-circuit board and is electrically connected to an electrode terminal connected to the conductive diaphram and becomes a ground potential and in this state, corona discharge is executed using the needle electrode above the fixed electrode and ions generated by the corona discharge are caused to arrive at the dielectric film concentratedly via the plurality of sound holes, thereby electretizing the dielectric film.

In electretizing, ions generated by corona discharge arrive at the dielectric film via a plurality of sound holes (openings for guiding a sound wave into the diaphram) made in the fixed electrode. Since ions are applied under a predetermined condition from one needle electrode with the dielectric film fixed to the ground potential, a large quantity of ions can be applied concentratedly to the dielectric film. Therefore, if the situation is not suited to applying ions to the dielectric film because of the internal structure of the microphone, the dielectric film can be electretized reasonably.

The electretization method of the invention contains a method wherein the dielectric film is electretized by executing more than one corona discharge.

Electretization processing is performed several times. Electretization can be executed reasonably and there is also an advantage for enhancing the accuracy of the electretization processing.

The electretization method of the invention contains a method wherein initial electretization processing of the dielectric film by executing corona discharge is executed under a predetermined condition and then a condition is again set and additional electretization processing by executing corona discharge is again executed.

For example, initial electretization is executed, thereby accomplishing the minimum electretization and then the condition is changed and additional electretization is executed for accomplishing any desired electretization. Electretization can be executed reasonably and there is also an advantage for enhancing the accuracy of the electretization processing.

The electretization method of the invention contains a method wherein after the initial electretization is executed, the sensitivity of the condenser microphone is measured, the condition of the additional electretization processing is determined based on the measurement result, and the additional electretization processing is executed under the determined condition.

To eliminate sensitivity variations caused by silicon microphone manufacturing variations (film thickness variations, etc.,), dielectric films are electretized one at a time in a given quantity to provide an electret condenser microphone and then the sensitivity of the electret condenser microphone is measured and the electretization condition quantity by additional corona discharge is determined based on the measurement result. Particularly, variations in the microphone sensitivity caused by manufacturing variations (film thickness variations, etc.,) can be absorbed by adjusting the electret quantity of the additional electretization processing and further sensitivity variations caused by FET (field-effect transistor) capacitor, parasitic capacity, etc., can also be absorbed by adjusting the electret quantity of the additional electretization processing. Therefore, it is also possible to take measures against variations in the microphone sensitivity caused by manufacturing variations and characteristic variations of parts.

The electretization method of the invention contains a method wherein the charge quantity of the dielectric film is adjusted according to the application voltage of the corona discharge.

According to the configuration, the electretization quantity can be adjusted according to the application voltage in the corona discharge.

The electretization method of the invention contains a method wherein the charge quantity of the dielectric film is adjusted according to the distance between the needle electrode for executing corona discharge and the dielectric film.

According to the configuration, the electretization quantity can be adjusted by adjusting the distance between the needle electrode and the dielectric film.

The electretization method of the invention contains a method wherein the charge quantity of the dielectric film is adjusted according to the corona discharge time.

According to the configuration, the electretization quantity can be adjusted by adjusting the duration of the corona discharge.

The electretization method of the invention contains a method wherein the charge quantity of the dielectric film is adjusted according to the ratio between minus ions and plus ions generated by corona discharge.

According to the configuration, the electretization quantity can be adjusted according to the ratio between minus ions and plus ions generated by corona discharge.

A condenser microphone of the invention has the dielectric film electretized by the electretization method of the invention as a condenser component.

According to the configuration, the condenser microphone formed by micromachining a silicon substrate, having a dielectric film manufactured using the electretization method described above as a condenser component is used, whereby a microminiature electret silicon condenser microphone (ESCM) having sensitivity enduring practical use can be provided.

An electretization apparatus of the invention is an electretization apparatus for executing the electretization method of the invention and has one needle electrode for executing at least one corona discharge separately for one condenser microphone, a high voltage source for applying a high voltage to the needle electrode, a ground pin for placing a film to be electretized in the condenser microphone in a ground potential, and a stage for placing an printed-circuit board on which the condenser microphone is implemented.

According to the configuration, the electretization apparatus is made up of the components for applying ions by corona discharge to one condenser microphone (containing the ground pin for grounding the film to be electretized) and the stage (mounting bed) for setting an printed-circuit board, so that it is made possible to perform electretization processing for a silicon microphone in an implementation state.

The electretization apparatus of the invention contains an electretization apparatus further having a sensitivity measurement section for measuring the sensitivity of the condenser microphone.

According to the configuration, the sensitivity measurement section of the electretized silicon condenser microphone is arranged in parallel with the electretization apparatus, so that it is made possible to measure the sensitivity of the microphone after electretization processing and set the condition of the next electretization processing based on the measurement result.

In the etectretixation apparatus of the invention, at least one of the application voltage of corona discharge, the distance between an electrode for executing corona discharge and the dielectric part, the corona discharge time, and the ratio between minus ions and plus ions generated by corona discharge can be adjusted.

According to the configuration, fine adjustment of the electret quantity is made possible by providing adjustment means capable of adjusting at least one of the application voltage of corona discharge, the distance from the dielectric film, the discharge time, and the polarity of discharge ions to adjust the electret quantity of one electretization processing. Particularly, the second electret amount is adjusted, whereby the stipulated microphone sensitivity can be obtained and accordingly it is made possible to adjust even a microphone having manufacturing variations or characteristic variations in electronic parts to the stipulated sensitivity.

The invention provides a manufacturing method of a condenser microphone using the electretization method described above, the manufacturing method including the steps of micromachining a semiconductor substrate, thereby machining the shape of a condenser microphone; implementing the condenser microphone on an printed-circuit board; and before or after the implementing step, connecting one electrode of the condenser microphone to a predetermined electrode through a terminal and executing at least one corona discharge using the electrode and a needle electrode separately for the condenser microphone, thereby electretizing a dielectric film of a component of the condenser microphone.

According to the configuration, it is made possible to provide microphones having uniform sensitivity with small manufacturing variations and characteristic variations.

### <Advantages of the Invention>

According to the invention, it is made possible to electretize the dielectric film to a stipulated quantity separately as for the silicon microphone provided by micromachining a silicon substrate. Electretization can also be executed in the implementation state, whereby it is made possible to form a silicon microphone having any desired characteristic with accuracy.

That is, hitherto, it has been difficult to adopt the electret system for the silicon microphone (silicon mic) because only the dielectric film cannot be taken out for electretization, but the invention makes it possible to manufacture an electret silicon microphone using the actual technique.

Variations in the microphone sensitivity caused by film thickness variations, etc., (device manufacturing variations) can also be compensated for by adjusting the electretization quantity.

Further, the invention also makes it possible to compensate for variations in the microphone sensitivity caused by variations in the electret quantity, parasitic capacity, FET capacitor, etc.

According to the invention, electretization is executed in a state in which the silicon condenser microphone is complete (in a state in which it is implemented on the printed-circuit board), and the electretization amount can be adjusted separately for adjusting the microphone sensitivity, so that the number of defective pieces of sensitivity out of the standard (stipulation) is decreased and the yield of microphone manufacturing improves dramatically. Therefore, mass production of electret silicon microphones is made possible.

### <Brief Description of the Drawings>

FIG. 1 is a sectional view of a device to describe the structure of a silicon microphone manufactured by micromachining a silicon substrate and an implementation mode thereof in a first embodiment of the invention.
FIG. 2 is a sectional view to show the implementation structure of an electret microphone using a silicon substrate (structure after the electret microphone is encapsulated in a case).
FIG. 3 is a drawing to show the main configuration of an electretization apparatus of the invention.
FIG. 4 is a process flowchart to show the main steps of the electretization method of the invention.
FIG. 5 is a drawing to show a configuration for measuring the sensitivity of a silicon microphone, arranged in parallel with the electretization apparatus in FIG. 3.
FIG. 6 is a schematic representation to show an electretization method of a second embodiment of the invention.
FIG. 7 is a sectional view of the main part of an apparatus for electretizing a dielectric film by causing corona discharge to occur using a needle electrode.
FIG. 8 is a sectional view of the main part of an apparatus for electretizing a dielectric film by causing corona discharge to occur using a wire electrode.

### <Description of Reference Numerals>

- 31: Fixed electrode
- 32: Dielectric film (inorganic dielectric film)
- 33: Diaphram electrode (diaphram)
- 34: Silicon substrate (silicon diaphragm)
- 35: Sound hole (opening) made in fixed electrode
- 36: Air gap formed by etching sacrifice layer
- 41: Shield case
- 42: Plastic or ceramic printed-circuit board
- 43: Semiconductor chip (silicon microphone chip) using silicon substrate
- 44 (44a, 44b): Bonding wire
- 45 (45a, 45b): Electronic part (FET, resistor, amplifier, etc.,)
- 46: Ground pattern
- 47: Microphone signal output pattern
- 49: Sound hole (opening) of microphone package
- 51: Needle electrode
- 52: Ground pin (electricity deposition device pin))
- 53: High voltage source
- 71: Loudspeaker
- 72: Loudspeaker amplifier
- 73: Sensitivity measurement apparatus
- 74: Sensitivity measurement apparatus pin (for ground pattern)
- 75: Sensitivity measurement apparatus pin (for microphone signal pattern)
- 76: Shield case for sensitivity measurement (for ground pattern)
- L1, L2: Wiring in printed-circuit board

### <Best Mode for Carrying out the Invention>

Embodiments of the invention will be discussed in detail with reference to the accompanying drawings.

### (First embodiment)

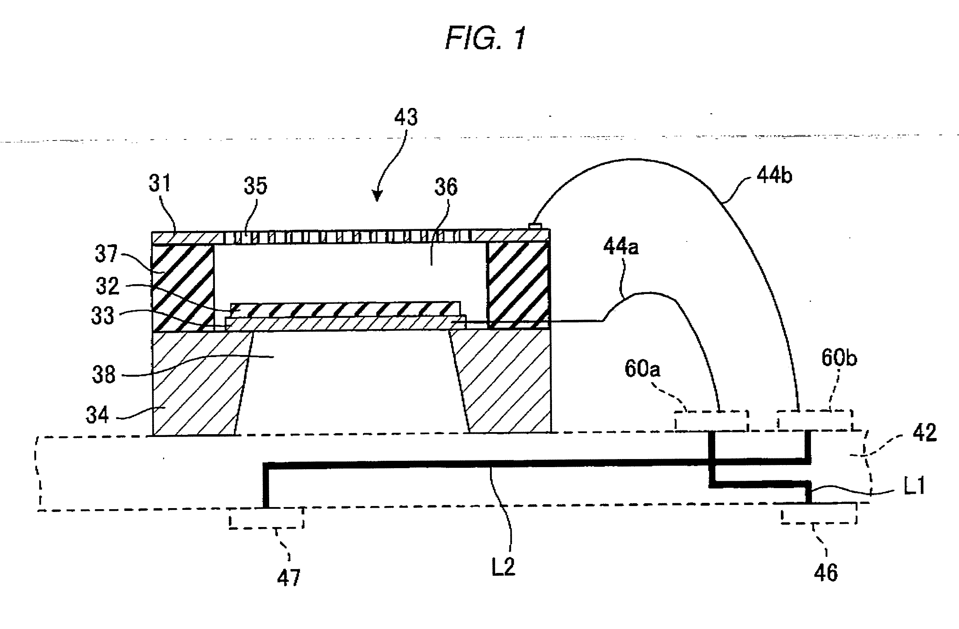

FIG. 1 is a sectional view of a device to describe the structure of a silicon microphone manufactured by micromachining a silicon substrate and an implementation mode thereof.

A silicon microphone 43 in FIG. 1 has a silicon substrate (silicon diaphragm) 34, a diaphram 33 functioning as one pole of a condenser, an inorganic dielectric film 32 as a film to be electretized, a spacer part 37, and a fixed electrode 31 functioning as an opposite electrode of the condenser. The fixed electrode 31 is provided with a plurality of sound holes (openings for guiding a sound wave into the diaphram 33) 35. Reference numeral 36 denotes an air gap.

The diaphram 33, the fixed electrode 31, and inorganic dielectric film 32 forming the microphone are manufactured using micromachining technology of silicon and manufacturing process technology of CMOS (complementary field-effect transistor).

The silicon microphone 43 is implemented on an printed-circuit board 42. The diaphram 33 forming one pole of the condenser and the fixed electrode 31 forming an opposite electrode of the condenser are electrically connected to wiring patterns 60a and 60b on the printed-circuit board through bonding wires 44a and 44b. The wiring patterns 60a and 60b are electrically connected to a ground pattern 46 and a microphone signal output pattern 47 provided on the back of the printed-circuit board 42 through internal wirings L1 and L2 of the printed-circuit board.

The silicon microphone 43 is manufactured using the micromachining technology for manufacturing MEMS elements and the CMOS manufacturing process technology of LSI.

That is, silicon substrate 34 is provided and silicon oxide film 33 doped with boron and phosphorus at a high concentration and silicon oxide film 32 (which is a dielectric film, and tetrafluoroethylene resin, etc., can also be used) are deposited on the silicon substrate 34 and a silicon layer is formed on the silicon oxide film using selectively epitaxial growth technology, etc. Impurities of phosphorus, boron, etc., are implanted at a high concentration into an area which becomes a sacrifice layer 36 of the silicon layer (portion removed by etching) and are diffused and silicon oxide film 31 which becomes a fixed electrode is formed on the silicon layer and is patterned for providing openings (sound holes) 35. Etching liquid is allowed to penetrate through the openings 35 and the portion of sacrifice layer 36 is removed using the etching rate difference between the silicon layer doped with the impurities at a high concentration and the undoped layer. Accordingly, the portion of the sacrifice layer becomes air gap 36 and at the same time, spacer part 37 is formed. The back of the silicon substrate 34 is etched in alkaline etching liquid of KOH, etc., to form a deep groove 38. Accordingly, the machined silicon substrate (silicon diaphragm) 34 is formed. Thus, the silicon microphone 43 is provided.

As described above, unlike the former ECM, the silicon microphone cannot be electretized with only the dielectric film taken out. Then, in the invention, the silicon oxide film 32 is electretized using corona discharge in a state in which a microphone is placed on an printed-circuit board.

However, in the silicon microphone 43 in FIG. 1, the inorganic dielectric film 32 is positioned between the fixed electrode 31 and the diaphram electrode 33 on the silicon substrate 34 and ions generated by corona discharge arrive at the inorganic dielectric film 32 via the openings (sound holes) 35 made in the fixed electrode 31. This means that the structure makes it hard for the ions generated by corona discharge to arrive at the inorganic dielectric film 32, and electretization of the inorganic dielectric film 32 needs to be devised,

To manufacture the silicon microphone 43, a silicon oxide film is deposited, thereby forming the diaphram electrode 33, the inorganic dielectric film 32, the fixed electrode 31, and the sacrifice layer for providing the air gap 36 and after the diffusion step terminates, the sacrifice layer is etched and this portion becomes the air gap 36. In the manufacturing process, variations in the film thickness of silicon layer at the mass production time (the film thickness determines the value of the air gap 36) occur about 10%. Thus, variations in the electrode-to-electrode distance between the diaphram electrode 33 and the fixed electrode 31 also occur about 10%. In the ECM, the microphone sensitivity is inversely proportional to the electrode-to-electrode distance. Therefore, variations in the electrode-to-electrode distance would lead to variations in the microphone sensitivity.

In the invention, this point is also considered and the dielectric film 32 is electretized reasonably and further device manufacturing variations or microphone sensitivity variations caused by the characteristic variations in electronic parts, etc., are absorbed by adjusting the electret quantity.

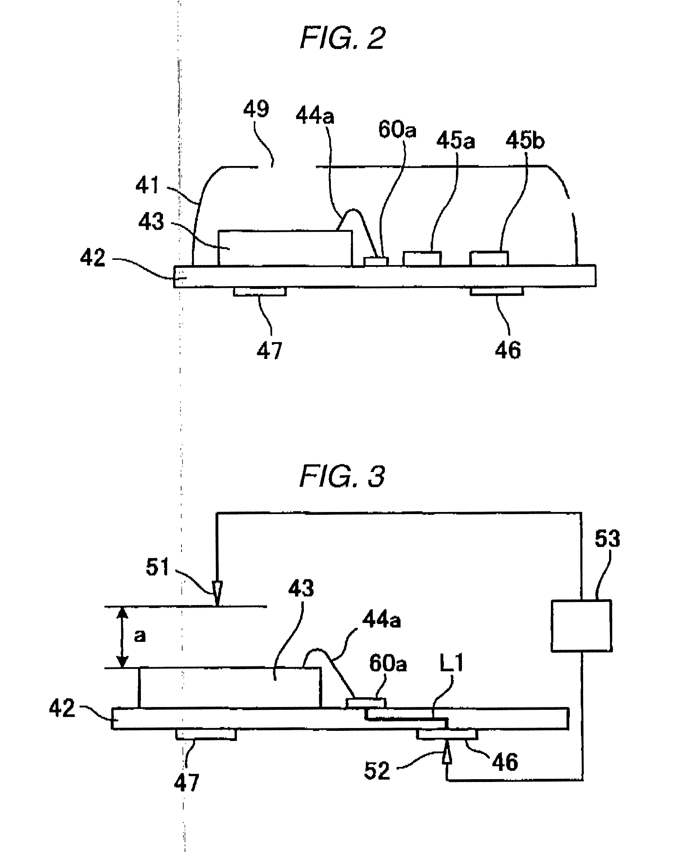

FIG. 2 is a sectional view to show the implementation structure of an electret microphone using a silicon substrate (structure after the electret microphone is encapsulated in a case). Parts common to those in FIG. 1 are denoted by the same reference numerals in FIG. 2. In FIG. 2, the silicon microphone (semiconductor device) 43 is drawn schematically (the actual structure is as shown in FIG. 1).

As shown in FIG. 2, the silicon microphone (semiconductor device) 43 and other elements (FET, resistance element, etc.,) 45 are implemented on the plastic or ceramic printed-circuit board 42.

A ground pattern 46 and a microphone signal output pattern 47 are placed on the back of the printed-circuit board 42, As shown in FIG. 1, the fixed electrode 31 and the diaphram electrode 33 of the silicon microphone (semiconductor device) 43 are connected to the wiring patterns 60a and 60b on the printed-circuit board 42 through the wires 44a and 44b. FIG. 2 shows only the wire 44a and the wiring pattern 60a.

A shield case 41 is attached onto the printed-circuit board 42 after electretization processing is complete. The shield case 41 is provided with a wide opening 49 for introducing a sound wave.

An electretization method of the invention (and an electretization apparatus of the invention) will be specifically discussed with FIGS. 3 to 5.

FIG. 3 is a drawing to show the main configuration of the electretization apparatus of the invention.

The electretization apparatus in FIG. 3 is a processing apparatus in a sheet manner (system of processing devices separately one at a time rather than a batch system of processing a plurality of devices at a time) for applying ions by corona discharge of one needle electrode to one silicon microphone for electretization.

As shown in the figure, the electretization processing uses corona discharge using a needle electrode 51. That is, the needle electrode 51 is positioned above the silicon microphone (semiconductor device) 43. A voltage source 53 for causing corona discharge to occur is connected to the needle electrode 51.

A ground pin (electricity deposition device pin) 52 is connected to the ground pattern 46 on the back of the printed-circuit board 42. The diaphram electrode 33 of the silicon microphone (see FIG. 1) is electrically connected to the ground pattern 46 provided on the back of the printed-circuit board 42 via the wire 44a, the wiring pattern 60a on the printed-circuit board 42, and the internal wiring L1 as described above. Therefore, the ground pin (electricity deposition device pin) 52 is connected to the ground pattern 46, whereby the diaphram electrode 33 becomes ground potential.

In this state, ions of corona discharge using the needle electrode 51 are applied to the dielectric film 32 in the silicon microphone 43 (see FIG. 1). Accordingly, the dielectric film 32 in the silicon microphone 43 (see FIG. 1) can be electretized reasonably.

That is, according to the corona discharge of the needle electrode 51, more ions than those of the corona discharge using the wire electrode shown in FIG. 8 can be applied concentratedly to the dielectric film 32 in the silicon microphone 43.

Therefore, as shown in FIG. 1, if ions are applied to the dielectric film 32 through the openings 35 of the fixed electrode 31 because of the structure of the microphone, an appropriate quantity of ions can be supplied and therefore the dielectric film 32 can be electretized. Since the dielectric film 32 in one silicon microphone (semiconductor device) 43 is electretized using one needle electrode 51, conditioning is easily carried out and therefore there is an advantage for improving accuracy of electretization.

Since ions are applied under a predetermined condition from one needle electrode 51 with the dielectric film 32 fixed to the ground potential, a large quantity of ions can be applied concentratedly to the dielectric film 32. Therefore, if the situation is not suited to applying ions to the dielectric film 32 because of the internal structure of the microphone, the dielectric film 32 can be electretized reasonably.

Next, a specific example of the electretization method of the invention will be discussed.

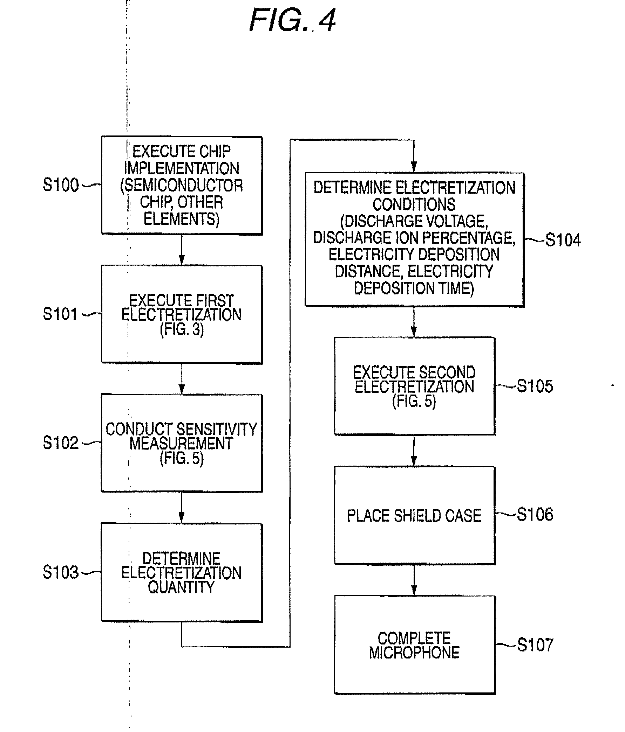

FIG. 4 is a process flowchart to show the main steps of the electretization method of the invention.

As shown in the figure, the electretization method in FIG. 4 is to electretize a dielectric film by more than one corona discharge.

That is, first, chip implementation is executed (step S100). That is, the silicon microphone (semiconductor chip) 43, other electronic parts (FET, resistance element, etc.,) 45, and the like are implemented on the printed-circuit board 42.

Next, the electretization apparatus in FIG. 3 is used to electretize the dielectric film 32 in the silicon microphone (semiconductor chip) 43 in a given quantity by corona discharge of the needle electrode 51 (step S101). Accordingly, an electret-condenser microphone can be formed.

Next, the sensitivity of the silicon microphone 43 is actually measured (step S102).

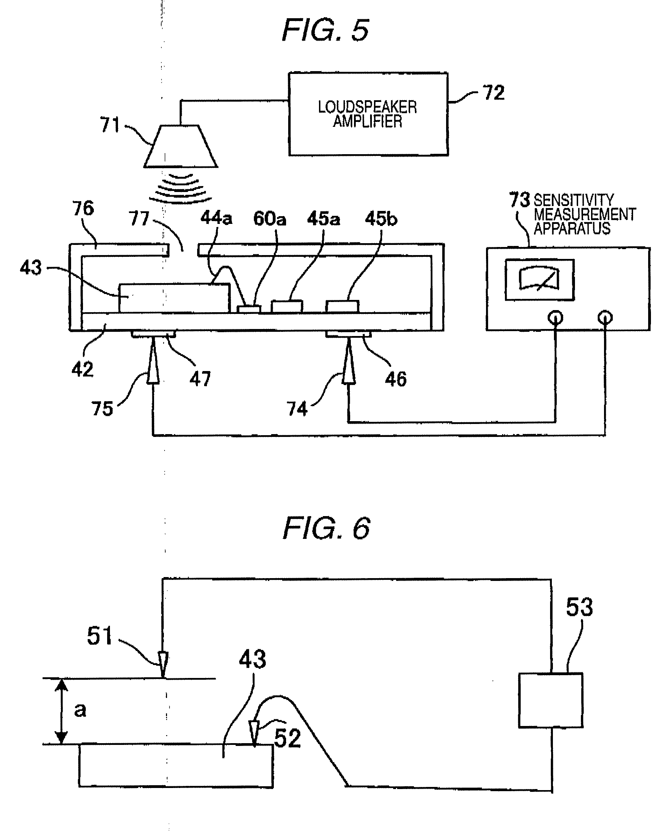

FIG. 5 is a drawing to show a configuration for measuring the sensitivity of a silicon microphone, arranged in parallel with the electretization apparatus in FIG. 3. Parts common to those in the accompanying drawings give above are denoted by the same reference numerals in FIG. 5. In FIG. 5, reference number 71 denotes a loudspeaker, reference number 72 denotes a loudspeaker amplifier, and reference number 73 denotes a sensitivity measurement apparatus. Reference number 76 denotes a shield case for sensitivity measurement. This shield case 76 is used only at the sensitivity measurement time (namely, is used in place of the shield case 41 in FIG. 2). The shield case 76 is provided with an opening 77 for allowing a sound wave to pass through. In the apparatus in FIG. 5, a sound of a given pressure is emitted from the loudspeaker 71 to the silicon microphone 43. At this time, measurement pins 74 and 75 are connected to the ground pattern 46 and the microphone signal output pattern 47 provided on the back of the printed-circuit board 42. The measurement pins are connected to the apparatus 73 for measuring the output signal of the microphone. The sound emitted from the loudspeaker 71 arrives at the diaphram 33 of the silicon microphone 43, causing the diaphram 33 to vibrate. In response to this, the capacity of the condenser changes, the capacity change is taken out as an electric signal, and the electric signal is sent through the measurement pins 74 and 75 to the sensitivity measurement apparatus 73. Accordingly, the sensitivity of the silicon microphone 43 subjected to electretization processing of a given quantity is measured.

Referring again to FIG. 4, then the electretization quantity required for the next etectretization processing (additional electretization processing) is determined based on the measurement result of the sensitivity of the silicon microphone 43 (step S103).

That is, usually, any desired microphone sensitivity cannot be provided by executing one electretization. Therefore, the electretization quantity required for obtaining the desired sensitivity is found according to the current measured sensitivity and characteristic information indicating the relationship between the electretization quantity and the microphone sensitivity.

When the electretization quantity in the second electretization processing is determined, then conditions in the electretization apparatus (electricity deposition apparatus) in FIG. 3 are set for executing electretization in the quantity exactly as determined (step 104 described later in detail).

The additional electretization processing is executed (step S105) and then the shield case 41 is placed as shown in FIG. 2 (step S106), whereby the silicon microphone shown in FIG. 2 is completed (step S107).

Next, step S104 (condition setting in the electretization apparatus) in FIG. 4 will be discussed.

Four elements are possible as the elements of the condition setting in the electretization apparatus (FIG. 3). That is, the elements are voltage, ion polarity, distance, and time. Precise electretization of the target electret quantity can be executed for the dielectric film 32 according to one of the elements or a combination thereof.

As described above, the electretization quantity can be adjusted by adjusting the corona discharge voltage. Adjustment of the corona discharge voltage is accomplished by changing the voltage value of power supply voltage 53 in the electretization apparatus in FIG. 3.

The higher the discharge voltage, the more generated ions and thus the higher the electricity deposition quantity (electretization quantity). At this time, if the discharge voltage is a given or less voltage, corona discharge does not occur. When a voltage of a given value or more is reached, discharge causes damage to the electret material. Therefore, an appropriate discharge voltage needs to be set between the upper limit value and the lower limit value. In the described embodiment, one electrode is connected to the ground potential, but the potential is not limited to the ground potential. The potential may be any if it allows a predetermined potential difference to be formed between the electrode and the needle electrode. To adjust the corona discharge voltage as described above, the potential connected to an electrode terminal may be shifted to the plus or minus side rather than the ground potential.

The electretization quantity can also be adjusted by adjusting the ratio between plus ions and minus ions of discharge ions by changing the polarity of the power supply voltage 53 according to the time as mentioned above.

The electretization quantity can also be adjusted by changing a distance a between the dielectric film 32 and the needle electrode 51 (see FIG. 3) as mentioned above. The shorter the distance a, the greater the electricity deposition quantity.

The electretization quantity can also be adjusted by changing the corona discharge time as mentioned above. The longer the discharge time, the greater the electricity deposition quantity.

Thus, electretization processing is performed several times (for example, initial electretization is executed, thereby accomplishing the minimum electretization and then the condition is changed and additional electretization is executed for accomplishing any desired electretization), whereby electretization can be executed reasonably and the accuracy of the electretization processing can also be enhanced.

After the first electretization, the sensitivity of the microphone is actually measured and the next electretization quantity is determined from the actual measurement result, whereby the microphone can be adjusted to the stipulated (standard) sensitivity.

Particularly, variations in the microphone sensitivity caused by manufacturing variations (film thickness variations, etc.,) can be absorbed by adjusting the electret quantity of the additional electretization processing and further sensitivity variations caused by FET (field-effect transistor) capacitor, parasitic capacity, etc., can also be absorbed by adjusting the electret quantity of the additional electretization processing.

Therefore, according to the invention, it is also possible to take measures against variations in the microphone sensitivity caused by manufacturing variations and characteristic variations of parts.

The condenser microphone of the invention manufactured through the process containing the electretization processing as described above is a microminiature condenser microphone formed by micromachining a silicon substrate, having a dielectric film manufactured using the electretization method of the invention as a condenser component. Therefore, the invention can provide a microminiature electret silicon condenser microphone (ESCM) having sensitivity enduring practical use and having a very excellent characteristic.

According to the invention, it is made possible to electretize the dielectric film to a stipulated quantity in the implementation state as for the silicon microphone provided by micromachining a silicon substrate.

That is, hitherto, it has been difficult to adopt the electret system for the silicon microphone (silicon mic) because only the dielectric film cannot be taken out for electretization, but the invention makes it possible to manufacture an electret silicon microphone using the actual technique.

Variations in the microphone sensitivity caused by film thickness variations, etc., (device manufacturing variations) can also be compensated for by adjusting the electretization quantity.

Further, the invention also makes it possible to compensate for variations in the microphone sensitivity caused by variations in the electret quantity, parasitic capacity, FET capacitor, etc.

According to the invention, electretization is executed in a state in which the silicon condenser microphone is complete (in a state in which it is implemented on the printed-circuit board), and the electretization amount can be adjusted separately for adjusting the microphone sensitivity, so that the number of defective pieces of sensitivity out of the standard (stipulation) is decreased and the yield of microphone manufacturing improves dramatically.

Therefore, mass production of electret silicon microphones is made possible.

Usually a silicon substrate is used as a semiconductor substrate, but a semiconductor substrate other than silicon, such as a compound semiconductor substrate can also be used, needless to say.

In the first embodiment described above, the electretization method is executed after a condenser microphone chip is installed, but may be executed before a condenser microphone chip is installed.

### (Second embodiment)

Next, a method of executing an electretization method before a condenser microphone chip is installed on an printed-circuit board will be discussed.

FIG. 6 is a drawing to show an electretization method of a second embodiment of the invention.

An etectretization apparatus in FIG. 6 is a processing apparatus in a sheet manner (system of processing devices separately one at a time rather than a batch system of processing a plurality of devices at a time) for applying ions by corona discharge of one needle electrode to one silicon microphone for electretization like the electretization apparatus in FIG. 3.

As shown in the figure, the electretization processing uses corona discharge using a needle electrode 51. That is, the needle electrode 51 is positioned above the silicon microphone (semiconductor device) 43. A voltage source 53 for causing corona discharge to occur is connected to the needle electrode 51.

A ground pin (electricity deposition device pin) 52 is electrically connected to a terminal 44a (see FIG. 1) taken out from a diaphram electrode 33 of a silicon microphone (see FIG. 1). Therefore, the ground pin (electricity deposition device pin) 52 is connected to the ground pattern 46, whereby the diaphram electrode 33 becomes ground potential.

In this state, ions of corona discharge using the needle electrode 51 are applied to a dielectric film 32 in the silicon microphone 43 (see FIG. 1). Accordingly, the dielectric film 32 in the silicon microphone 43 (see FIG. 1) can be electretized reasonably.

Lastly, the silicon microphone 43 thus electretized is implemented on any desired printed-circuit board.

### <Industrial Applicability>

The invention produces the advantage that electretization of a highly accurate dielectric film is realized reasonably in the silicon microphone (silicon mic) using a semiconductor chip formed by micromachining a silicon substrate, and is useful as a microminiature silicon microphone installed in a mobile communication machine, an electretization method of the silicon microphone, and an electretization apparatus used for manufacturing the silicon microphone.

## Claims

1. An electretization method of electretizing a dielectric film of a component of a condenser microphone formed by micromachining a semiconductor substrate, wherein
one electrode of the condenser microphone is connected to a predetermined potential through a terminal and at least one corona discharge using the electrode and a needle electrode is executed separately for the condenser microphone, thereby electretizing the dielectric film.

2. The electretization method as claimed in claim 1 wherein
the condenser microphone has a fixed electrode having a plurality of sound holes, a diaphram placed with a predetermined spacing from the fixed electrode, the dielectric film provided on the diaphram, and a conductive diaphram abutted against the dielectric film, and is implemented on an printed-circuit board, and wherein
the dielectric film in the condenser microphone is provided on the printed-circuit board and is electrically connected to an electrode terminal connected to the conductive diaphram and becomes a ground potential and in this state, corona discharge is executed using the needle electrode above the fixed electrode and ions generated by the corona discharge are caused to arrive at the dielectric film concentratedly via the plurality of sound holes, thereby electretizing the dielectric film.

3. The electretization method as claimed in claim 1 or 2 wherein
the dielectric film is electretized by executing more than one corona discharge.

4. The electretization method as claimed in claim 3 wherein
initial electretization processing of the dielectric film by executing corona discharge is executed under a predetermined condition and then a condition is again set and additional electretization processing by executing corona discharge is again executed.

5. The electretization method as claimed in claim 4 wherein
after the initial electretization is executed, the sensitivity of the condenser microphone is measured, the condition of the additional electretization processing is determined based on the measurement result, and the additional electretization processing is executed under the determined condition.

6. The electretization method as claimed in any of claims 1 to 5 wherein
the charge quantity of the dielectric film is adjusted according to the application voltage of the corona discharge.

7. The electretization method as claimed in any of claims 1 to 5 wherein
the charge quantity of the dielectric film is adjusted according to the distance between the needle electrode for executing corona discharge and the dielectric film.

8. The electretization method as claimed in any of claims 1 to 5 wherein
the charge quantity of the dielectric film is adjusted according to the corona discharge time.

9. The electretization method as claimed in any of claims 1 to 5 wherein
the charge quantity of the dielectric film is adjusted according to the ratio between minus ions and plus ions generated by corona discharge.

10. A condenser microphone **characterized in that** it has the dielectric film electretized by an etectretization method as claimed in any of claims 1 to 9 as a condenser component.

11. An electretization apparatus for executing an electretization method as claimed in any of claims 1 to 9, said electretization apparatus having:
one needle electrode for executing at least one corona discharge separately for one condenser microphone, a high voltage source for applying a high voltage to said needle electrode, a ground pin for placing a film to be electretized in the condenser microphone in a ground potential, and a stage for placing an printed-circuit board on which the condenser microphone is implemented.

12. The electretization apparatus as claimed in claim 11
further having a sensitivity measurement section for measuring the sensitivity of the condenser microphone.

13. The electretization apparatus as claimed in claim 11 or 12 wherein
at least one of the application voltage of corona discharge, the distance between an electrode for executing corona discharge and the dielectric part, the corona discharge time, and the ratio between minus ions and plus ions generated by corona discharge can be adjusted.

14. A manufacturing method of a condenser microphone using an electretization method as claimed in any of claims 1 to 9, said manufacturing method including the steps of:
micromachining a semiconductor substrate, thereby machining the shape of a condenser microphone;
implementing the condenser microphone on an printed-circuit board; and
before or after said implementing step, connecting one electrode of the condenser microphone to a predetermined electrode through a terminal and executing at least one corona discharge using the electrode and a needle electrode separately for the condenser microphone, thereby electretizing a dielectric film of a component of the condenser microphone.
